# EUROPÄISCHE PATENTSCHRIFT

(11) **EP 1 184 335 B1**
(45) Veröffentlichungstag und Bekanntmachung des Hinweises auf die Patenterteilung: **01.02.2006**
(21) Anmeldenummer: 01117577.5
(22) Anmeldetag: 20.07.2001
(51) Int. Cl.: B81B 3/00

(54) **Bauelement für Sensoren mit intergrierter Elektronik und Verfahren zu seiner Herstellung, sowie Sensor mit intergrierter Elektronik**
Device for sensors with integrated electronics and its method of manufacture, and sensor with integrated electronics
Dispositif pour capteurs avec électronique intégrée et sa méthode de fabrication, et capteur avec électronique intégrée

(30) Priorität: 31.08.2000 DE 10042945
(43) Veröffentlichungstag der Anmeldung: 06.03.2002
(73) Patentinhaber: SIEMENS AKTIENGESELLSCHAFT, 80333 München (DE)
(72) Erfinder: Bruchhaus, Rainer, Dr., Yokohama-shi, Kanagawa-Pref. 224-0014 (JP); Kolb, Stefan, 85716 Unterschleissheim (DE); Pitzer, Dana, 85716 Unterschleissheim (DE); Primig, Robert, 81541 München (DE); Schreiter, Matthias, 81379 München (DE); Winkler, Bernhard, 81243 München (DE)

(56) Entgegenhaltungen:
- DE-A- 19 645 036
- US-A- 5 942 791
- TANAKA A ET AL: "INFRARED FOCAL PLANE ARRAY INCORPORATING SILICON IC PROCESS COMPATIBLE BOLOMETER" IEEE TRANSACTIONS ON ELECTRON DEVICES, IEEE INC. NEW YORK, US, Bd. 43, Nr. 11, 1. November 1996 (1996-11-01), Seiten 1844-1848, XP000636276 ISSN: 0018-9383
- COLE B E ET AL: "Monolithic arrays of micromachined pixels for infrared applications" , ELECTRON DEVICES MEETING, 1998. IEDM '98 TECHNICAL DIGEST., INTERNATIONAL SAN FRANCISCO, CA, USA 6-9 DEC. 1998, PISCATAWAY, NJ, USA,IEEE, US, PAGE(S) 459-462 XP010321480 ISBN: 0-7803-4774-9 * Absatz [0002] * * Abbildung 1 *

## Beschreibung

Die vorliegende Erfindung betrifft ein Bauelement für Sensoren mit integrierter Elektronik gemäß dem Oberbegriff von Patentanspruch 1, einen Sensor mit integrierter Elektronik gemäß dem Oberbegriff von Patentanspruch 11, sowie ein Verfahren zur Herstellung eines Bauelements für Sensoren mit integrierter Elektronik gemäß dem Oberbegriff von Patentanspruch 13.

Integrierte Sensoren und Sensorarrays werden in zunehmendem Maße mit Techniken der Mikromechanik hergestellt. Derartige Sensoren bzw. Sensorarrays umfassen z. B. mechanische Sensoren oder thermische Sensoren, bei denen auf einem Halbleitertragkörper ein oder mehrere Sensorelemente ausgebildet sind, wobei in dem Halbleitertragkörper eine elektronische Schaltung zur Auslesung der Sensorelemente integriert ist.

Beispielsweise ist bei integrierten Infrarotsensoren bzw. hochauflösenden Infrarot-Detektorarrays auf dem Halbleitertragkörper bzw. Chip ein Sensorelement zur Messung der Intensität einer Infrarotstrahlung ausgestaltet, z.B. in Form eines pyroelektrischen Kondensators. Neben dem Sensorelement bzw. der Sensorstruktur befindet sich auf dem Chip weiterhin eine Ausleseelektronik, die zur Verarbeitung der von der Sensorstruktur erzeugten Signale dient. Dabei sind die Ausleseelektronik und die Sensorstruktur nebeneinander auf dem Chip aufgebracht. Die Ausleseelektronik ist im Chip integriert.

Allgemeiner Stand der Technik zum Thema Infrarotsensor ist der US 5 403 752, der US 5 684 302 und der US 5 939 722 zu entnehmen.

Aus der DE 196 45 036 ist eine Halbleiter-Detektoreinrichtung für Infrarotstrahlung bekannt, die unterhalb des für Infrarotstrahlung sensitiven Materials einen geschlossenen Hohlraum aufweist. Dieser Hohlraum ist zur Erhöhung des thermischen Widerstands evakuiert und wird nach oben hin von einer Membran abgeschlossen, welche durch stehen gelassene Teile einer Opferschicht gestützt wird. Eine Ausleseelektronik ist seitlich des Hohlraums mit im Chip integriert.

Der Artikel "infrared focal plane array incorporating silicon IC process compatible bolometer" von A. Tanaka et al., veröffentlicht in IEEE Transactions on Electron Devices, Vol. 43, Nr. 11, Nov. 1996, beschreibt ein monolithisch integriertes Bauelement mit einem Bolometer-Array, das sich oberhalb einer CMOS Ausleseelektronik befindet. Die elektrische Anbindung der einzelnen Bolometer an die Ausleseelektronik erfolgt über Stützen mit einem Aluminiumkern.

Weitere Sensoren mit mikromechanisch hergestellten Strukturen sind z. B. Drucksensoren, Beschleunigungssensoren und Kraftsensoren. Auch bei derartigen Sensoren können Schaltungen bzw. Ausleseelektroniken im Chip integriert sein.

Die bekannten Sensoren mit integrierter Elektronik haben jedoch den Nachteil eines großen Platzbedarfs, da die Elektronik und die Sensorstruktur bzw. das Sensorelement auf dem Chip nebeneinander aufgebracht sind. Dies führt dazu, dass auf einer vorgegebenen Fläche oder Detektorfläche bzw. bei einer vorgegebenen Chipgröße in einem integrierten Sensorarray die Anzahl der Sensorelemente begrenzt ist. Dadurch kann z. B. die Qualität der Messergebnisse beschränkt werden und es ergibt sich insbesondere bei bildgebenden oder optischen Sensoren eine verschlechterte Auflösung.

Ein weiterer Nachteil bekannter Sensorstrukturen ist die mangelnde Stabilität gegenüber mechanischen Einflüssen von außen, insbesondere bei Chips, die in ihrem Inneren Hohlräume aufweisen und sehr dünn ausgestaltet sind. Darüber hinaus sollen die Sensoren bzw. deren Bauelemente oder Sensorstrukturen kostengünstig herstellbar sein.

Es ist daher die Aufgabe der vorliegenden Erfindung, ein Bauelement für Sensoren mit integrierter Elektronik zu schaffen, das einen reduzierten Platzbedarf hat, so dass Sensoren mit integrierter Elektronik kleiner hergestellt werden können. Weiterhin soll ein Sensor mit integrierter Elektronik geschaffen werden, der eine geringe Baugröße aufweist. Darüber hinaus soll ein Verfahren angegeben werden, mit dem integrierte Sensoren und/oder deren Bauelemente bzw. Komponenten klein und kostengünstig herstellbar sind.

Die Aufgabe wird gelöst durch das Bauelement gemäß Patentanspruch 1, den Sensor gemäß Patentanspruch 11, und durch das Verfahren zur Herstellung eines Bauelements für Sensoren mit integrierter Elektronik gemäß Patentanspruch 13. Weitere vorteilhafte Merkmale, Aspekte und Details der Erfindung ergeben sich aus den abhängigen Ansprüchen, der Beschreibung und den Zeichnungen.

Das erfindungsgemäße Bauelement für Sensoren mit integrierter Elektronik umfasst ein Substrat zum Tragen eines Sensorelements, elektronische Bauelemente, die in das Substrat integriert sind, beispielsweise die Verschaltung der Bauelemente, die in das Substrat integiret ist und damit auch eine Schaltung zur Auslesung des zu tragenden Sensorelements, wobei eine Hilfsschicht auf dem Substrat angeordnet und mit mindestens einem Hohlraum versehen ist, und wobei eine Membran den Hohlraum nach oben begrenzt, um das Sensorelement in vertikaler Anordnung zur elektronischen Schaltung zu tragen.

Insbesondere durch die vertikale Anordnung der beiden Teile Ausleseelektronik und Sensorelement bzw. Hohlraumbauelement wird die Fläche, die für intelligente Sensoren mit integrierter Elektronik benötigt wird, wesentlich verkleinert. Somit können z.B. Sensoren in einem Array wesentlich dichter aneinander angeordnet werden. Damit werden insbesondere mit CMOSkompatibler Mikromechanik z.B. hochauflösende IR-Detektorarrays zugänglich bzw. herstellbar, die einen verringerten Platzbedarf haben.

Bevorzugt ist der Hohlraum abgeschlossen und/oder evakuiert. Dadurch erfolgt vor allem eine thermische Isolierung der einzelnen Sensorelemente, so dass diese noch dichter angeordnet werden können. Insbesondere bei Infrarotsensoren oder allgemein bei optischen oder bildgebenden Sensoren wird durch eine gute thermische Isolierung die Qualität der Messergebnisse und die Auflösung wesentlich verbessert.

Vorteilhafterweise sind unter dem Hohlraum elektronische Bauelemente angeordnet, während oberhalb des Hohlraums eine Verdrahtung der Bauelemente ausgebildet ist. Dadurch wird zusätzlicher Platz eingespart.

Bevorzugt dienen z.B. oberflächenmikromechanisch hergestellte Stützstrukturen zum Abstützen der Membran. Dabei können die Stützstrukturen eine Metallisierung umfassen und somit neben ihrer Stützfunktion auch zur Kontaktierung der unterhalb des Hohlraums gelegenen Bauelemente dienen. Insbesondere sind die Stützstrukturen säulenartig ausgestaltet. Dadurch ergibt sich eine verbesserte Tragfähigkeit bei kleinerer Ausgestaltung. Durch die Stützstrukturen und den Hohlraum wird das Übersprechen zwischen einzelnen Sensorelementen bzw. Pixeln vermindert und es erfolgt gleichzeitig eine Kontaktierung der Bauelemente z.B. der Schaltung zu einer Metallisierung auf der gegenüberliegenden Seite des Hohlraums.

Die Stützstrukturen sind z.B. aus Si-Oxid gefertigt, wobei insbesondere ein elektrischer Kontakt in die Stützstrukturen eingebettet ist. Dadurch wird auf besonders einfache und kostengünstige Weise eine sehr wirksame Abstützung und gleichzeitige Durchkontaktierung erzielt.

Die Hilfsschicht kann ein oder mehrere durchgehende Kontaktlöcher aufweisen, die sich insbesondere senkrecht zur Hilfsschicht durch diese erstrecken und z.B. mit einem Metall oder Edelmetall, insbesondere Wolfram, gefüllt sind. Die Kontaktlöcher können dabei in Bereichen der Hilfsschicht ausgebildet sein, die als Stützstrukturen zum Abstützen der Membran ausgestaltet sind. Dadurch können bei der Herstellung Kosten gespart werden, wobei die Stützstrukturen dennoch in ihrer Funktion eine hohe Güte aufweisen.

Bevorzugt ist eine Passivierung auf dem Substrat unterhalb der Hilfsschicht ausgebildet. Dadurch werden die elektronischen Schaltungen bzw. Bauelemente geschützt. Die Passivierung bzw. Schutzschicht wird gegebenenfalls strukturiert. Sie dient insbesondere auch als Ätzstop für die Hohlraumätzung und beispielsweise als Gegenelektrode in einem Sensor.

Gemäß einem anderen Aspekt der Erfindung wird ein Sensor mit integrierter Elektronik bereitgestellt, der ein erfindungsgemäßes Bauelement wie es oben beschrieben ist und nachfolgend noch näher erläutert wird, umfasst, wobei auf dem Bauelement ein Sensorelement in vertikaler Anordnung zur integrierten elektronischen Schaltung angeordnet ist. Der Sensor kann sehr klein ausgestaltet werden und dennoch sehr gute Messergebnisse bzw. hohe Auflösungen liefern.

Der Sensor kann z.B. als Infrarotsensor ausgestaltet sein und/oder ein IR-Detektorarray bilden. Dabei sind eine Vielzahl derartiger Sensoren bevorzugt in einem einzigen Chip ausgebildet.

Das erfindungsgemäße Verfahren zur Herstellung eines Bauelements für Sensoren mit integrierter Elektronik umfasst die Schritte: Bereitstellen eines Substrats, das mit Bauelementen einer Ausleseelektronik versehen ist; Aufbringen einer Hilfsschicht auf das Substrat, so dass die Bauelemente überdeckt werden; Aufbringen einer Membranschicht auf die Hilfsschicht; und Entfernen von Bereichen der Hilfsschicht, so dass mindestens ein Hohlraum gebildet wird, wobei Stützstrukturen aus Material der Hilfsschicht bestehen bleiben, die sich von der Membranschicht ausgehend vertikal nach unten zu den Bauelementen hin erstrecken und in die ein elektrisch leitender Kontakt eingebettet ist oder eingebettet wird. Mit dem Verfahren kann auf kostengünstige Weise ein erfindungsgemäßes Bauelement bzw. ein erfindungsgemäßer integrierter Sensor hergestellt werden.

Bevorzugt wird vor dem Aufbringen der Hilfsschicht eine Passivierung auf das Substrat aufgebracht, welche die Bauelemente der Ausleseelektronik überdeckt. Dadurch werden die darunter liegenden Bauelemente geschützt.

Vorteilhaft werden in der Hilfsschicht ein oder mehrere senkrechte Kontaktlöcher ausgebildet, die mit Metall gefüllt werden, insbesondere mit Wolfram.

Auf die Membranschicht wird bevorzugt eine Metallisierung aufgebracht, um die Bauelemente untereinander und/oder mit dem hergestellten Bauelement für Sensoren zu verschalten.

Vorteile, Merkmale und Details der Erfindung, die unter Bezugnahme auf das Verfahren zur Herstellung des Bauelements oder Sensors angegeben werden, gelten selbstverständlich auch für das Bauelement bzw. den Sensor selbst, ebenso wie Vorteile und Merkmale des Bauelements oder Sensors auch für das erfindungsgemäße Verfahren gelten.

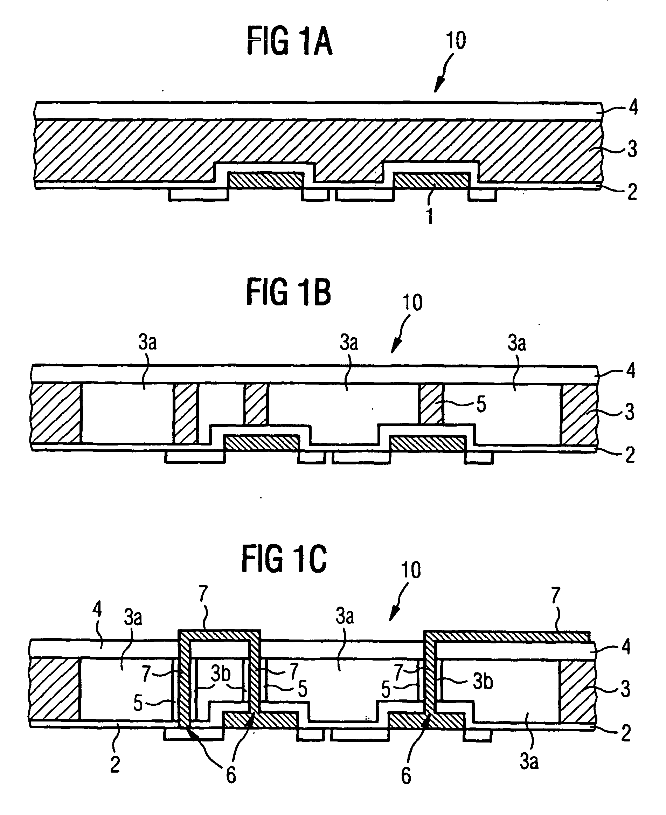

Nachfolgend wird zunächst das Verfahren zur Herstellung des Bauelements und anschließend das Bauelement selbst beispielhaft anhand der Figur beschrieben. Dabei zeigt
- Fig. 1 A bis C: eine bevorzugte Ausführungsform des erfindungsgemäßen Bauelements schematisch in verschiedenen Phasen seiner Herstellung,

Figur 1 A zeigt als Ausgangspunkt für die Herstellung eines Bauelements 10 für integrierte Sensoren ein Substrat 1 in Form eines Wafers, der beispielsweise mit Bauelementen einer Ausleseelektronik bzw. einer elektronischen Schaltung oder teilen davon versehen ist. Die Bauelemente der Ausleseelektronik sind im Substrat 1 integriert bzw. enthalten und haben Kontaktflächen zur elektrischen Kontaktierung. Die Ausleseelektronik dient zur Auslesung und/oder Signalverarbeitung eines Sensorelements, das später von dem Bauelement 10 getragen wird.

Auf dem Substrat 1 befindet sich eine Passivierung 2 in Form einer Schutzschicht, die auf geeignete Weise je nach den Anforderungen des herzustellenden Sensors strukturiert ist. Die Passivierung dient zum Schutz der darunter liegenden Bauelemente der elektronischen Schaltung und dient gleichzeitig als Atzstop. Gegebenenfalls bildet diese Schicht eine Gegenelektrode in einem Sensor, der mit Hilfe des erfindungsgemäßen Bauelements 10 hergestellt wird.

Über der Passivierung 2 bzw. Schutzschicht ist eine Hilfsschicht 3 aufgebracht, die als Opferschicht für die spätere Hohlraumätzung dient. Die Hilfsschicht 3 ist im vorliegenden Fall beispielsweise eine 0,5 µm dicke Plasmaoxid- oder TEOS-Schicht, die auf geeignete Weise planarisiert ist.

Auf der Oberseite der Passivierung 2 bzw. des Oxids wird eine weitere Schicht 4 aufgebracht, die eine Membran bzw. Membranschicht bildet. Die Membran ist beispielsweise aus Poly-Si gefertigt.

Fig. 1 B zeigt den Zustand des Bauelements 10 nach einem weiteren Verfahrensschritt. Dabei werden Bereiche der Hilfsschicht 3 zwischen der Passivierung 2 und der Membran 4 entfernt, so dass Hohlräume 3a in dem Bauelement 10 ausgebildet werden, die durch die Passivierung 2, die Membran 4 und durch das restliche Material der Hilfsschicht 3 begrenzt werden. Das Bilden der Hohlräume erfolgt z.B. durch Ätzen. Hierzu werden beispielsweise in die Membran 4 ein oder mehrere Löcher eingebracht, durch die die Hohlraumätzung erfolgt. Anschließend können die Löcher z.B. durch Aufbringen einer geeigneten Verschlussschicht wieder verschlossen werden.

Bei der Hohlraumätzung wird der Ätzprozess so geführt, dass Säulen aus Si-Oxid stehen bleiben. Diese Säulen bilden Stützstrukturen 5, welche die Membran 4 mit den später darauf angeordneten Sensorelementen abstützen. Zumindest einige der säulenartigen Stützstrukturen erstrecken sich oberhalb der Kontaktierungen bzw. Kontaktflächen der integrierten Auswerteelektronik durch den Hohlraum 3a senkrecht nach oben zur Membran 4. In die Stützstrukturen werden später Kontakte bzw. Leiterbahnen in Form von Metallisierungen eingebettet.

Je nach den Anforderungen des Sensors erfolgt das Verschließen der Hohlräume unter Vakuumbedingungen, so dass evakuierte Hohlräume 3a im Bauelement 10 vorhanden sind, auf denen Sensor- oder Pixelelemente ausgebildet werden können, um einen integrierten Sensor zu bilden.

Fig 1 C zeigt das Bauteil mit Metallisierungen 7, die sich auf der Oberseite der Membran 4 und senkrecht durch das Bauelement 10 hindurch erstrecken. Die Metallisierungen 7 können z.B. eine Standard-Mehrlagenmetallisierung sein. Sie dienen zum Verschalten der elektronischen Bauelemente bzw. Logik-Bauelemente untereinander und/oder mit dem HohlraumBauelement 10.

Die Metallisierungen 7 erstrecken sich im Inneren der Stützstrukturen 5 aus Si-Oxid, so dass diese jeweils eine elektrische Leitung zur Kontaktierung der unterhalb des Hohlraums 3a gelegenen Ausleseelektronik von oben her durch den Hohlraum 3a hindurch bilden.

Zur Bildung dieser Leitungen werden Kontaktlöcher 3b in die Stützstrukturen 5 geätzt, die anschließend mit Wolfram aufgefüllt werden. Alternativ dazu ist es auch möglich, die Kontaktlöcher 3b mit den eingebrachten Metallisierungen 7 vor der Hohlraumätzung zu füllen. Auch können die Metallisierungen 7 auf der Membran 4 vor der Herstellung der Hohlräume 3a aufgebracht werden.

Das in Fig. 1 C gezeigte Bauelement 10 dient als Struktur zur Bildung von Sensoren, wobei die elektronischen Bauelemente der Schaltung zur Auslesung des vom Bauelement 10 zu tragenden Sensorelements im Substrat 1 integriert ist. In der Hilfsschicht 3 oberhalb des Substrats 1 bzw. oberhalb der Schaltung ist der Hohlraum 3a ausgebildet, der nach oben hin von der Membran 4 begrenzt ist bzw. durch die Membran 4 abgeschlossen ist. Die Membran 4 ist so ausgestaltet, dass sie das aufzubringende Sensorelement in vertikaler Anordnung in Bezug auf die elektronische Schaltung trägt.

Die Stützstrukturen 5 mit den integrierten Metallisierungen 7 verbinden die unterhalb des Hohlraums 3a gelegenen Bauelemente bzw. Schaltungen mit der Oberfläche der Membran 4, so dass eine vertikale Kontaktierung von Anschlüssen 6 der Ausleseelektronik senkrecht zur Waferebene durch den Hohlraum 3a hindurch erfolgt.

Zur Bildung eines erfindungsgemäßen Sensors wird auf dem Bauelement 10 vertikal über der Ausleseelektronik und über dem jeweils zugehörigen Hohlraum 3a ein Sensorelement ausgebildet, das je nach den Erfordernissen der zu detektierenden bzw. zu messenden Größe ausgestaltet ist. Das Sensorelement ist beispielsweise ein integrierter IR-Detektor. In diesem Fall kann das Sensorelement z.B. durch einen pyroelektrischen Kondensator gebildet sein, der aus zwei Elektroden mit einer dazwischen liegenden PZT-Schicht (Bleizirkonattitanat-Schicht) besteht.

Das Sensorelement kann aber auch zur Messung anderer Größen ausgestaltet sein, beispielsweise zur Messung von Kräften oder Beschleunigungen, wobei die konkrete Ausgestaltung mit Techniken der Mikromechanik erfolgt.

Das Bauelement 10 kann eine Struktur zum Tragen einer Vielzahl von Sensorelementen sein, so dass sich bei aufgebrachten Sensorelementen ein Sensorarray ergibt, insbesondere in Form eines IR-Detektorarrays.

## Patentansprüche

1. Bauelement für Sensoren mit integrierter Elektronik, mit
- einem Substrat (1),
- elektronischen Bauelementen, die in das Substrat (1) integriert sind und die zur Auslesung des zu tragenden Sensorelements dienen,
- einer Hilfsschicht (3), die auf dem Substrat (1) angeordnet ist und die mit mindestens einem abgeschlossenen Hohlraum (3a) versehen ist,
- einer Membran (4) zum Tragen eines Sensorelements, den Hohlraum (3a) nach oben begrenzt und
- aus der Hilfsschicht oberflächenmikromechanisch hergestellten und im Hohlraum angeordneten Stützstrukturen zum Abstützen der Membran,
**dadurch gekennzeichnet, dass**
- unter dem Hohlraum (3a) die elektronischen Bauelemente angeordnet sind, und
- die Stützstrukturen (5) eine Metallisierung umfassen zur Kontaktierung der unterhalb des Hohlraums (3a) gelegenen Bauelemente.

2. Bauelement nach Anspruch 1, **dadurch gekennzeichnet, dass** der Hohlraum (3a) evakuiert ist.

3. Bauelement nach Anspruch 1 oder 2, **dadurch gekennzeichnet, dass** oberhalb des Hohlraums (3a) eine Verdrahtung der Bauelemente ausgebildet ist.

4. Bauelement nach einem der Ansprüche 1 bis 3, **dadurch gekennzeichnet, dass** die Stützstrukturen (5) säulenartig ausgestaltet sind.

5. Bauelement nach einem der Ansprüche 1 bis 4, **dadurch gekennzeichnet, dass** die Stützstrukturen (5) aus Si-Oxid gefertigt sind, wobei die Metallisierung in die Stützstrukturen (5) eingebettet ist.

6. Bauelement nach einem der vorhergehenden Ansprüche, **dadurch gekennzeichnet, dass** die Stützstrukturen der Hilfsschicht (3) ein oder mehrere durchgehende Kontaktlöcher (3b) aufweisen, die sich senkrecht zur Hilfsschicht (3) erstrecken und die zur Bildung der Metallisierung mit einem Metall oder Edelmetall, insbesondere Wolfram, gefüllt sind.

7. Bauelement nach einem der vorhergehenden Ansprüche, **gekennzeichnet durch** eine Passivierung (2), die auf dem Substrat (1) unterhalb der Hilfsschicht (3) ausgebildet ist.

8. Sensor mit integrierter Elektronik, **gekennzeichnet durch** ein Bauelement (10) nach einem der vorhergehenden Ansprüche, auf dem ein Sensorelement in vertikaler Anordnung zur integrierten elektronischen Schaltung angeordnet ist.

9. Sensor nach Anspruch 8, **dadurch gekennzeichnet, dass** er als Infrarotsensor ausgestaltet ist und/oder ein IR-Detektorarray bildet.

10. Verfahren zur Herstellung eines Bauelements nach einem der Ansprüche 1 bis 7 für Sensoren mit integrierter Elektronik, **gekennzeichnet durch** die Schritte:
Bereitstellen eines Substrats (1), das mit Bauelementen einer Ausleseelektronik versehen ist;
Aufbringen einer Hilfsschicht (3) auf das Substrat (1), so dass die Bauelemente überdeckt werden;
Aufbringen einer Membranschicht (4) auf die Hilfsschicht (3);
Entfernen von Bereichen der Hilfsschicht (3), so dass mindestens ein Hohlraum gebildet wird,
wobei Stützstrukturen aus Material der Hilfsschicht (3) bestehen bleiben, die sich von der Membranschicht (4) ausgehend vertikal nach unten zu den Bauelementen hin erstrecken und in die ein elektrisch leitender Kontakt eingebettet ist oder eingebettet wird.

11. Verfahren nach Anspruch 10, **dadurch gekennzeichnet, dass** vor dem Aufbringen der Hilfsschicht (3) eine Passivierung (2) auf das Substrat (1) aufgebracht wird, die die Bauelemente der Ausleseelektronik überdeckt.

12. Verfahren nach Anspruch 10 oder 11, **dadurch gekennzeichnet, dass** in der Hilfsschicht (3) ein oder mehrere senkrechte Kontaktlöcher (3b) ausgebildet werden, die mit Metall gefüllt werden, insbesondere mit Wolfram.

13. Verfahren nach einem der Ansprüche 10 bis 12, **dadurch gekennzeichnet, dass** auf die Membranschicht (4) eine Metallisierung (7) aufgebracht wird, um die Bauelemente untereinander und/oder mit dem hergestellten Bauelement für Sensoren zu verschalten.

## Revendications

1. Dispositif pour capteurs avec électronique intégrée, comprenant :
- un substrat (1),
- des dispositifs électroniques intégrés dans le substrat (1) et servant à la lecture de l'élément de capteur qui va être porté,
- une couche auxiliaire (3) située sur le substrat (1) et pourvue d'au moins un espace creux (3a) isolé,
- une membrane (4) pour porter un élément de capteur, qui limite l'espace creux (3a) vers le haut et
- des structures de support pour supporter la membrane, formées par micromécanique de surface à partir de la couche auxiliaire et situées dans l'espace creux,
**caractérisé en ce que**
- les dispositifs électroniques sont situés sous l'espace creux (3a) et
- les structures de support (5) entourent une métallisation pour établir le contact avec les dispositifs situés au-dessous de l'espace creux (3a).

2. Dispositif selon la revendication 1, **caractérisé en ce que** le vide est fait dans l'espace creux (3a).

3. Dispositif selon la revendication 1 ou 2, **caractérisé en ce qu'**un câblage des dispositifs est formé au-dessus de l'espace creux (3a).

4. Dispositif selon l'une des revendications 1 à 3, **caractérisé en ce que** les structures de support (5) sont exécutées à la manière de colonnes.

5. Dispositif selon l'une des revendications 1 à 4, **caractérisé en ce que** les structures de support (5) sont en oxyde de silicium, la métallisation étant insérée dans les structures de support (5).

6. Dispositif selon l'une des revendications précédentes, **caractérisé en ce que** les structures de support de la couche auxiliaire (3) sont pourvues d'un ou plusieurs trou(s) de contact continu(s) (3b) qui s'étend(ent) perpendiculairement à la couche auxiliaire (3) et qui est(sont) remplis d'un métal ou d'un métal précieux, notamment de wolfram, pour former la métallisation.

7. Dispositif selon l'une des revendications précédentes, **caractérisé par** une couche de passivation (2) formée sur le substrat (1) au-dessous de la couche auxiliaire (3).

8. Capteur avec électronique intégrée, **caractérisé par** un dispositif (10) selon l'une des revendications précédentes, sur lequel un élément de capteur est disposé en position verticale par rapport au circuit électronique intégré.

9. Capteur selon la revendication 8, **caractérisé en ce qu'**il est exécuté en tant que capteur d'infrarouge et/ou **en ce qu'**il forme une matrice de détecteurs d'infrarouge.

10. Procédé pour fabriquer un dispositif selon l'une des revendications 1 à 7 pour des capteurs avec électronique intégrée, **caractérisé par** les étapes:
préparation d'un substrat (1) pourvu de dispositifs d'une électronique de lecture ;
application d'une couche auxiliaire (3) sur le substrat (1) de manière à ce que les dispositifs soient couverts ;
application d'une couche de membrane (4) sur la couche auxiliaire (3) ;
retrait de zones de la couche auxiliaire (3) de manière à former au moins un espace creux,
des structures de support formées du matériau de la couche auxiliaire (3) étant laissées en place, structures qui s'étendent verticalement vers le bas depuis la couche de membrane (4) jusqu'aux dispositifs et dans lesquelles un contact électroconducteur est inséré ou va être inséré.

11. Procédé selon la revendication 10, **caractérisé en ce qu'**une couche de passivation (2) couvrant les dispositifs de l'électronique de lecture est appliquée sur le substrat (1) avant d'appliquer la couche auxiliaire (3).

12. Procédé selon la revendication 10 ou 11, **caractérisé en ce que** l'on forme dans la couche auxiliaire (3) un ou plusieurs trou(s) de contact vertical(aux) (3b) qui est(sont) rempli(s) de métal, notamment de wolfram.

13. Procédé selon l'une des revendications 10 à 12, **caractérisé en ce qu'**une métallisation (7) est appliquée sur la couche de membrane (4) pour connecter les dispositifs les uns aux autres et/ou avec le dispositif pour capteurs fabriqué.

## Claims

1. Component for sensors with integrated electronics, with
- a substrate (1),
- electronic components which are integrated into the substrate (1) and are used for reading out the sensor element to be carried,
- an auxiliary layer (3) which is arranged on the substrate (1) and which is provided with at least one enclosed cavity (3a),
- a membrane (4) for carrying a sensor element, which delimits the cavity (3a) upwards, and
- support structures manufactured micromechanically from the auxiliary layer and arranged in the cavity to support the membrane,
**characterized in that**
- the electronic components are arranged below the cavity (3a), and
- the support structures (5) include a metalization for contacting the components lying below the cavity (3a).

2. Module in accordance with claim 1,
**characterized in that**, the cavity (3a) is evacuated.

3. Component in accordance with claim 1 or 2,
**characterized in that**, wiring of the components is embodied above the cavity (3a).

4. Component in accordance with one of the claims 1 to 3,
**characterized in that** the support structures (5) are embodied in the form of pillars.

5. Component in accordance with one of the claims 1 to 4,
**characterized in that** the support structures (5) are made from Si-oxide, with the metalization being embedded in the support structures (5).

6. Component in accordance with one of the previous claims,
**characterized in that** the support structures of the auxiliary layer (3) feature one or more pass-through contact holes (3b) which extend perpendicular to the auxiliary layer (3) and, to form the metalization, are filled with a metal or noble metal, especially tungsten.

7. Component in accordance with one of the previous claims,
**characterized by** a passivation (2) which is embodied on the substrate (1) below the auxiliary layer (3).

8. Sensor with integrated electronics,
**characterized by** a component (10) in accordance with one of the previous claims, on which a sensor element is disposed in a vertical arrangement to the integrated electronic circuit.

9. Sensor in accordance with claim 8,
**characterized in that** it is embodied as an infrared sensor and/or forms an IR detector array.

10. Method for manufacturer of a component in accordance with one of the claims 1 to 7 for sensors with integrated electronics, **characterized by** the steps:
Provision of a substrate (1) which is provided with components of a readout electronics;Application of an auxiliary layer (3) to the substrate (1), so that the components are covered;Application of a membrane layer (4) to the auxiliary layer (3);
Removal of areas of the auxiliary layer (3), so that at least one cavity is formed,
with support structures made of material of the auxiliary layer (3) remaining, which extend down vertically starting at the membrane layer (4), to the components and into which an electrically-conductive contact is embedded or will be embedded.

11. Method according to claim 10, **characterized in that**, before the auxiliary layer is applied (3), a passivation (2) is applied to the substrate (1) which covers the components of the readout electronics.

12. Method in accordance with claim 10 or 11,
**characterized in that** , in the auxiliary layer (3) one or more perpendicular contact holes (3b) are embodied which are filled with metal, especially with tungsten.

13. Method in accordance with one of the claims 10 to 12,
**characterized in that** a metalization (7) is applied to the membrane layer (4) to interconnect the components and/or to connect them to the manufactured component for sensors.
